# EUROPEAN PATENT APPLICATION

(11) **EP 1 876 139 A2**
(43) Date of publication of application: **09.01.2008**
(21) Application number: 07100792.6
(22) Date of filing: 19.01.2007
(51) Int. Cl.: B81B 3/00

(54) **Bi-axially driven MEMS Device**

(30) Priority: 22.06.2006 KR 20060056549
(71) Applicant: Samsung Electronics Co., Ltd., Suwon-si, Gyeonggi-Do (KR)
(72) Inventor: Ko, Young-chul, Gyeonggi-do (KR); Cho, Jin-woo, Gyeonggi-do (KR); Park, Yong-hwa, Gyeonggi-do (KR); Jeong, Hee-moon, Gyeonggi-do (KR)
(74) Representative: Greene, Simon Kenneth

(57) **Abstract**

Provided is a two-axis micro-electro mechanical system (MEMS) device. The MEMS device includes a moving plate, a stage, a driving coil, a pair of magnets, and a yoke magnetic body. The moving plate is supported coaxially on a first axis to move pivotably about the first axis that is disposed perpendicularly to a second axis. The stage is supported coaxially on the second axis in an inner region of the moving plate. The driving coil includes a coaxial coil portion arranged along the first axis of the driving plate and divided at a center by the stage, and a first connecting coil portion and a second connecting coil portion. The magnets of the pair are respectively disposed. The yoke magnetic body is disposed between the pair of magnets in a region above or below the magnets and is formed of a material capable of being magnetized by the magnets in order to suddenly change a magnetic flux density according to a distance between the pair of magnets. The MEMS device provides reliable driving about the two axes and doubles the rotation force.

## Description

### BACKGROUND OF THE INVENTION

The present invention relates to a micro-electro mechanical system (MEMS) device, and more particularly, to a two-axis MEMS device that can rotate around two mutually perpendicular axes.

Recently, research on MEMS devices that can be manufactured using semiconductor manufacturing technology is actively being pursued in various technological fields such as display devices, laser printers, precision measurement, and precision manufacturing. For example, much research is conducted for developing MEMS devices that can be used in display devices for irradiating a beam incident from a light source onto a predetermined display region to form an image, and MEMS devices that can be used for developing miniature MEMS light scanners that collect light irradiated onto and reflected from a predetermined display region in order to read image information.

Such a MEMS device includes a reflecting mirror for reflecting incident light. The reflective mirror has a horizontal axis and a vertical axis that rotate perpendicularly to one another, and irradiates light incident from a light source two-dimensionally onto a predetermined display region. That is, the mirror forms a plurality of irradiated light lines onto the display through the rotation within a predetermined irradiation angular range about the horizontal axis, and simultaneously moves a beam spot from the upper portion to the lower portion of the display while rotating within another predetermined injection angular range about the vertical axis. When irradiation on one display ends, the location of the beam spot returns to the upper portion of the display.

In one configuration of a conventional two-axis MEMS device, driving coils are wound around the reflecting mirror, a pair of first magnets are disposed facing each other in a horizontal rotation direction of the reflective mirror with the mirror in the middle, and a pair of second magnets are disposed facing each other in a vertical rotation direction of the reflective mirror with the mirror in the middle. The magnetic fields formed by the pairs of first and second magnets interact with the magnetic field formed by a current flowing through the driving coils to provide a rotational moment respectively about the vertical and horizontal rotational axes, thereby driving the reflective mirror about two axes. In another configuration of a conventional two-axis light scanner, a reflective mirror wrapped in a driving coil is disposed between a pair of magnets facing one another, and the horizontal and vertical rotational axes of the reflective magnet are diagonally disposed with respect to the magnetic field formed by the pair of magnets. The magnetic field that intersects with the current flowing through the driving coil provides a rotational moment about one of the axes. The component of force from the rotational moment along the horizontal rotational axis and that in the vertical rotational axis are used to rotate the reflective mirror about the two axes.

However, in the conventional configurations having the pairs of first and second magnets, since the magnets are necessarily disposed proximally to one another, magnetic interference is produced that causes a loss of driving power and a vibration mode with unwanted noise components. Also, in the conventional configuration having the horizontal and vertical rotational axes disposed diagonally with respect to the magnetic field and using the resultant components of the rotational force, the rotational force components from the same rotational moment are used to drive the mirror about the two axes. Thus, in order to obtain precise horizontal and vertical scanning at different frequencies when resonance generally appears, very precise controlling technology is required. Additionally, an alignment error between the magnetic field and the rotational axes immediately affects the distribution of force between the horizontal and vertical driving forces.

### SUMMARY OF THE INVENTION

The present invention provides a MEMS device that is reliably driven bi-axially and has twice the driving power of a conventional MEMS device.

According to an aspect of the present invention, there is provided a micro-electro mechanical system (MEMS) device including: a moving plate supported coaxially on a first axis to move pivotably about the first axis that is disposed perpendicularly to a second axis; a stage supported coaxially on the second axis in an inner region of the moving plate; a driving coil including a coaxial coil portion arranged along the first axis of the moving plate and divided at a center by the stage, and a first connecting coil portion and a second connecting coil portion respectively connecting left and right end portions of the coaxial coil portion to one another at opposite ends thereof; a pair of magnets having opposite polarities and respectively disposed proximally to the first and second connecting coil portions to form a magnetic field transversely across the driving coil; and a yoke magnetic body disposed between the pair of magnets in a region above or below the magnets and formed of a material capable of being magnetized by the magnets in order to suddenly change a magnetic flux density according to a distance between the pair of magnets.

According to another aspect of the present invention, there is provided a MEMS device including: a moving plate supported coaxially on a first axis to move pivotably about the first axis that is disposed perpendicularly to a second axis, and including a stage region formed at a center thereof; a driving coil including a coaxial coil portion arranged along the first axis of the moving plate and divided by the stage region, and a first connecting coil portion and a second connecting coil portion respectively connecting left and right end portions of the coaxial coil portion to one another at opposite ends thereof; a pair of magnets having opposite polarities and respectively disposed proximally to the first and second connecting coil portions to form a magnetic field transversely across the driving coil; and a yoke magnetic body disposed between the pair of magnets in a region above or below the magnets and formed of a material capable of being magnetized by the magnets in order to suddenly change a magnetic flux density according to a distance between the pair of magnets.

According to another aspect of the present invention, there is provided a MEMS device including: a gimbal supported to move about a first axis; a moving plate supported to move pivotably about a second axis, and including a stage region formed at a center thereof; a driving coil including a coaxial coil portion arranged along the first axis of the moving plate and divided by the stage region, and a first connecting coil portion and a second connecting coil portion respectively connecting left and right end portions of the coaxial coil portion to one another at opposite ends thereof; a pair of magnets having opposite polarities and respectively disposed proximally to the first and second connecting coil portions to form a magnetic field transversely across the driving coil; and a yoke magnetic body disposed between the pair of magnets in a region above or below the magnets and formed of a material capable of being magnetized by the magnets in order to suddenly change a magnetic flux density according to a distance between the pair of magnets.

### BRIEF DESCRIPTION OF THE DRAWINGS

The above and other features and advantages of the present invention will become more apparent by describing in detail exemplary embodiments thereof with reference to the attached drawings in which:
FIG. 1 is a plan view of a MEMS device according to an embodiment of the present invention;
FIG. 2 is a plan view of the MEMS device in FIG. 1, to illustrate rotation about a second axis;
FIG. 3 is a vertical sectional view of the MEMS device in FIG. 1 taken along line III-III;
FIGS. 4 and 5 respectively illustrate the magnetic flux distribution and magnetic flux vector distribution of the magnetic field formed only by a pair of magnets in the MEMS device of FIG. 1;
FIG. 6 illustrates the magnetic flux vector distribution of the magnetic field when a yoke magnetic body is disposed between a pair of magnets in the MEMS device of FIG. 1;
FIGS. 7A through 7C are graphs illustrating the distribution of magnetic flux density formed between a pair of magnets in the MEMS device of FIG. 1 at different vertical positions.
FIGS. 8 through 10 are plan views of MEMS device structures according to other embodiments of the present invention; and
FIG. 11 is a vertical sectional view of FIG. 10 taken along line XI-XI.

### DETAILED DESCRIPTION OF THE INVENTION

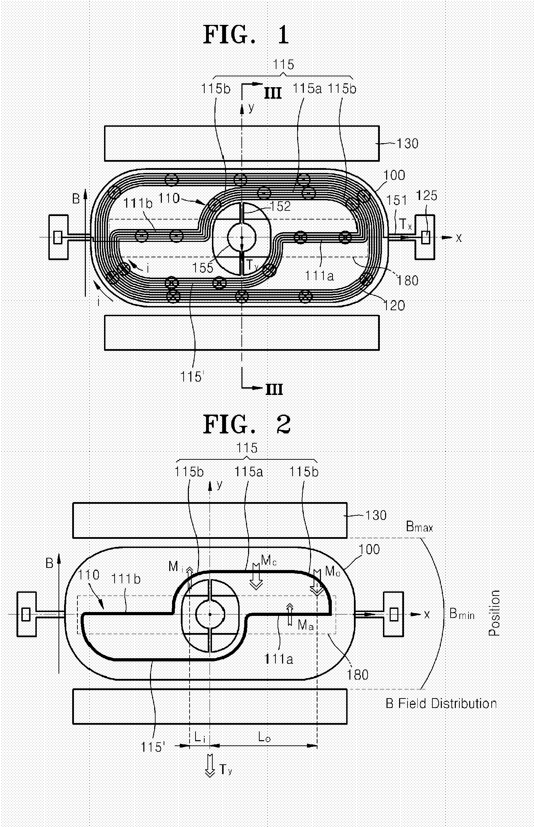

A MEMS device according to preferred embodiments of the present invention will now be described more fully with reference to the accompanying drawings in which exemplary embodiments of the invention are shown. FIG. 1 is a plan view of a MEMS device according to an embodiment of the present invention. Referring to FIG. 1, the MEMS device includes a moving plate 100 supported about a first axis (x-axis), a stage 155 supported about a second axis (y-axis) within the moving plate 100, a driving coil 110 wound on the moving plate 100, and a pair of magnets 130 with the moving plate 100 disposed therebetween. The moving plate 100 is supported at either end by a first axis member 151, and pivots about the first axis (x-axis) and the second axis (y-axis) that is perpendicular to the first axis. To elastically support the moving plate that pivots around two axes, the first axis member 151 is made of a type of elastic spring that can twist along the axial direction and bend in a direction vertical to the ground surface. The stage 155 supported by a second axis member 152 is provided within the moving plate 100. The stage 155 receives the rotation motion of the moving plate 100 through the second axis member 152, and rotates about the x-axis and the y-axis in conjunction with the moving plate 100.

The driving coil 110 is wound in a closed loop configuration around the stage 155 on the moving plate 100. In further detail, the driving coil 110 includes coaxial coil portions 111a and 111b disposed along the first axis (x-axis), and first and second connecting coil portions 115 and 115' that connect the ends of the coaxial coil portions 111a and 111b. The coaxial coil portions 111a and 111b are arranged along the first axis (x-axis), and are divided into the two portions by the stage 155 in the center of the moving plate 100. Each of the first and second connecting coil portions 115 and 115' connect the left and right ends of the coaxial coil portions 111a and 111b at mutually opposite positions, so that they are arranged proximally to the magnets 130. The connecting coil portions 115 and 115' may include straight coil portions 115a that are spaced from and run parallel to the first axis (x-axis), and curved coil portions 115b at either end of the straight coil portions 115a that form a rounded shape. For example, the straight coil portions 115a may extend for the same length as one segment of the coaxial coil portions 111a and 111b, and the curved coil portions 115b may be partial circles with a predetermined radius.

An auxiliary coil 120 may be further provided around the outside of the driving coil 110. The auxiliary coil 120 may be wound along the perimeter of the moving plate 100 to be symmetrical with respect to the first axis (x-axis) and the second axis (y-axis). The auxiliary coil 120 is not an essential element of the present invention; however, it may contribute to the speed at which the stage 155 is driven and allow for an increased displacement by increasing the rotational moment. The driving coil 110 and the auxiliary coil 120 are continuously wound in a corresponding shape with the same thin metal wire, and may be electrically connected to share different signals. Reference number 125 refers to a contact terminal for applying a driving current to the driving coil 110 and the auxiliary coil 120.

The pair of magnets 130 are disposed to face each other with the moving plate 100 therebetween, and form a magnetic field B in a direction traversing the driving coil 110 to generate electromagnetic forces Tx and Ty according to the Lorentz's Law. Generally, the magnetic field B formed by the pair of magnets 130 gradually attenuates in magnetic flux density in the direction of the magnetic field (y-axis). Thus, the connecting coil portion 115 disposed near the magnets are in a high density magnetic flux region, and the coaxial coil portions 111a and 111b disposed at the central portion of the moving plate 100 relatively far from the magnets 130 are in a low density magnetic flux region. Accordingly, there is a non-uniform electromagnetic force inducted to each connecting coil portion 115 and 115' and the coaxial coil portions 111a and 111b.

A predetermined current (i) that passes through the driving coil 110 interacts with the magnetic field B formed by the pair of magnets 130 to induce an electromagnetic force in the direction shown in FIG. 1. For example, when the driving current (i) circulates in a clockwise direction, an electromagnetic force is exerted on the first connecting coil portion 115 in a direction pushing it upward from a ground surface, and an electromagnetic force is exerted on the second connecting coil portion 115' pushing it downward toward the ground surface. Here, the electromagnetic forces in mutually opposite directions acting on the first and second connecting coil portions 115 and 115' act as a pair of forces with respect to the first axis (x-axis) to generate a rotational moment to pivot the moving plate 100 in the same direction. Here, the coaxial coil portions 111a and 111b arranged on the first axis (x-axis) do not have a moment arm about the same first axis (x-axis), so that they cannot provide a rotational moment. The rotational status of the moving plate 100 about the second axis (y-axis) is determined according to the values of the rotational moments provided by each portion of the driving coil 110. Referring to FIG. 2 for a more detailed description, the rotational moment (Mc) of the straight coil portion 115a located near the magnet 130 is relatively larger than the rotational moment (Ma) of the coaxial coil portions 111a and 111b (Mc>>Ma). This is due to the magnetic flux distribution of the magnetic field B formed between the magnets 130. The straight coil portion 115a uses a high magnetic flux density (close to Bmax) for inducing electromagnetic force, while on the other hand, the coaxial coil portions 111a and 111b use a low magnetic flux density (Bmin). Therefore, the rotational moment (Mc) of the straight coil portion 115a overcomes the rotational moment (Ma) of the coaxial coil portions 111a and 111b to pivot the moving plate 100 in the same direction. Here, to rapidly change the magnetic flux density according to the relative distance with the magnets 130, when the gradient is increased, the magnetic flux density between the coaxial coil portions 111a and 111b exposed to the minimum magnetic flux density (Bmin) and the straight coil portions 115 and 115' exposed to the maximum magnetic flux density (Bmax) may be increased, so that the force non-uniformity aids the rotation about the second axis (y-axis). Further, to rapidly change the magnetic flux distribution of the magnetic field B of the present invention, a yoke magnetic body 180 is disposed between the magnets 130. This will be described in detail below.

With respect to the second axis (y-axis), the curved coil portion 115b disposed relatively far away has a longer moment arm (Lo>>Li) than the curved coil portion 115b to the inside of the moving plate, so that the rotational moment of the outer curved coil portion 115b overcomes the rotational moment of the inner curved coil portion 115b (Mo>>Mi), and the moving plate 100 is rotated in the same direction. As a result, the rotation of the moving plate 100 about the second axis (y-axis) uses the non-uniformity of the rotational moments at portions of the driving coil 110, and uses the differences of the rotational moments (Mc-Ma) and (Mo-Mi) as the driving force. Referring to the electromagnetic force distribution induced in the auxiliary coil 120 in FIG. 1, the auxiliary coil 120 provides an additional rotational moment about the first axis (x-axis), and provides an additional rotation moment about the second axis (y-axis) due to force equilibrium.

When a positively charged driving current circulating clockwise is applied to a negatively charged driving current circulating counterclockwise, the moving plate 100 pivots in reverse directions about the first axis (x-axis) and the second axis (y-axis), so that positively and negatively charged alternating current signals discharged at predetermined frequencies are applied to drive the moving plate 100 to pivot about the first axis (x-axis) and the second axis (y-axis). The moving plate 100 can move about the first axis (x-axis) and the second axis (y-axis) at respectively different first and second frequencies - for example, it may be driven about the first axis (x-axis) at 60Hz and the second axis (y-axis) at 25kz. To this end, the driving signal applied to the driving coil 110 may be in a superposed format with a driving signal having the first frequency and a driving signal having the second frequency. The stage 155 within the moving plate 100 receives the movement about the two axes (x-axis and y-axis) through the secondary axis member 152. The stage 155 may rotate about the first axis (x-axis) and second axis (y-axis), and irradiate light incident from a light source onto a display region in two-dimensions. For example, the stage 155 rotates within a predetermined irradiation angle about the second axis (y-axis) at a high frequency to form a plurality of irradiating lines on the display (for horizontal irradiation), and rotates within another predetermined irradiation angle about the first axis (x-axis at a low frequency to move the irradiation angle in a vertical direction (for vertical irradiation).

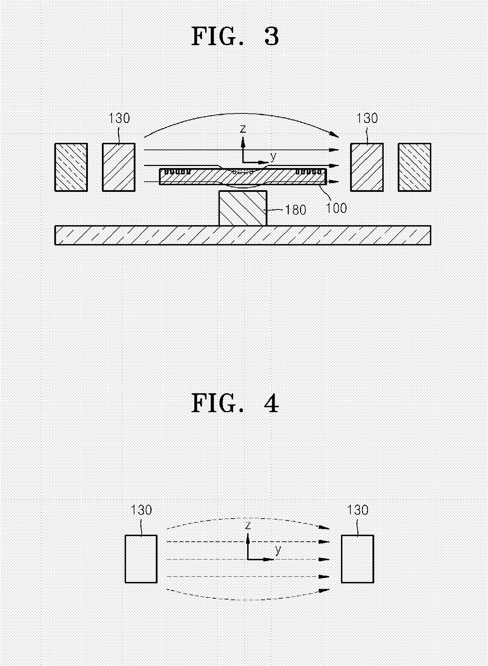

FIG. 3 is a vertical sectional view of the MEMS device in FIG. 1 taken along line III-III. Referring to FIG. 3, the moving plate 100 is disposed between the pair of magnets 130 facing one another, and the yoke magnetic body 180 is disposed between the pair of magnets 130 at a region below. The yoke magnetic body 180 is formed of a ferromagnetic or paramagnetic material that can be magnetized by the magnets 130. For example, it may be formed mostly of iron having a relative permeability of 2500.

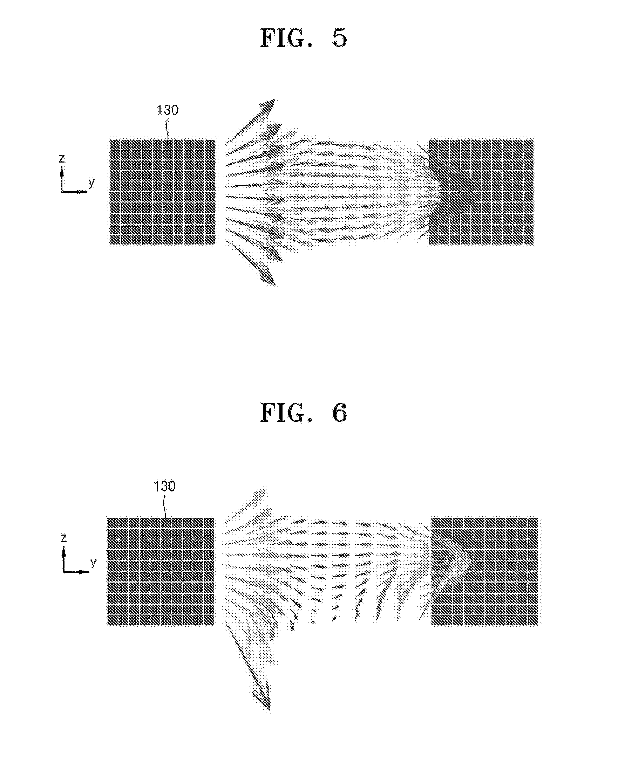

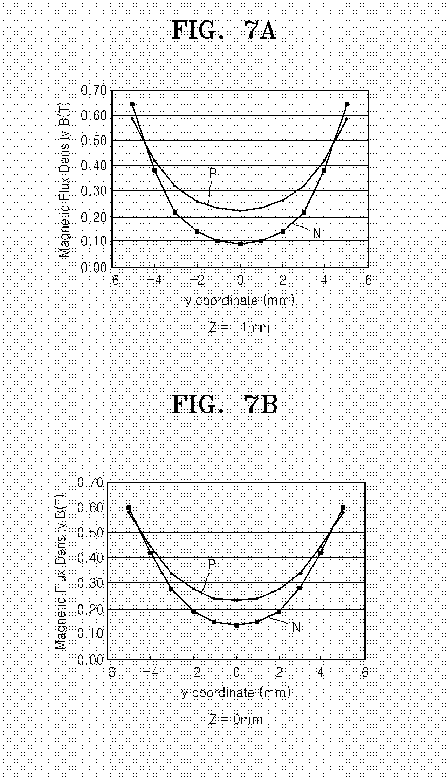

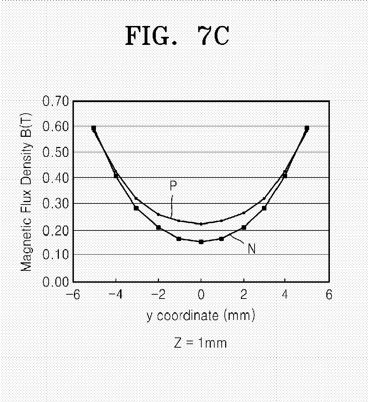

FIGS. 4 and 5 respectively illustrate the magnetic flux distribution and magnetic flux vector distribution of the magnetic field formed by the pair of magnets 130. Referring to FIGS. 4 and 5, the magnetic flux density is greatest at the surface of the magnets where the magnetic field is focused, and as the magnetic field emitted from the magnets 130 expands, the magnetic flux density is gradually reduced, so that the magnetic flux density is lowest at the central region between the magnets 130. FIGS. 3 and 6 illustrate the yoke magnetic body 180 disposed between the pair of magnets 130 and magnetic flux lines and magnetic flux vectors in the space between the magnets 130. Referring to FIGS. 3 and 6, the magnetized yoke magnetic body 180 causes the magnetic flux line (magnetic flux vector) to curve over the yoke magnetic body 180, and the magnetic field expands and the magnetic flux density is gradually reduced toward the middle between the magnets 130 where the yoke magnetic body 180 is disposed. FIGS. 7A through 7C are graphs illustrating the distribution of magnetic flux density formed between magnets 130, at different vertical positions (on a z-axis). Here, the vertical height (on the z-axis) begins at the middle of the magnets (where z = 0). Referring to FIGS. 7A through 7C, the horizontal axis is the position along the electric field direction (along the y-axis), and the vertical axis shows the magnetic flux density B. In a magnetic field with a profile P formed only with a pair of magnets 130, there is no sudden variation based on a change in vertical height (z = -1, 0, 1), and the approximate distribution ranges from a maximum of 0.58T to a minimum of 0.23T, reflecting a deviation of approx. 0.35T. When a yoke magnetic body 180 is added, the magnetic field with a profile N has a lower minimum magnetic flux density and an increased deviation in magnetic flux density. At vertical heights of z = -1, 0, and 1, the variations in magnetic flux density are 0.56T, 0.46T, and 0.42T, respectively. The variation in magnetic flux density increases in the spaces around the yoke magnetic body 180 with a low vertical height. Therefore, in the rotating about the second axis (y-axis) that uses the variations in magnetic flux density, the vertical position of the moving plate 100 is adjusted so that moving plate 100 is proximal to the yoke magnetic body 180, thereby increasing the rotating force.

In Table 1 below, the comparative ratios of the minimum to maximum magnetic flux densities (Bmin/Bmax) are varied to calculate the first axis rotational moment Tx and the second axis rotational moment Ty. Referring to Table 1, the comparative ratio of magnetic flux density (Bmin/Bmax) drops and the first axis rotational moment Tx lessens accordingly. On the other hand, as the comparative ratio of magnetic flux density (Bmin/Bmax) drops, the second axis rotational moment Ty gradually increases. When the yoke magnetic body 180 is disposed between the magnets 130, the magnetic flux density changes suddenly, so that when the magnetic flux density ratio (Bmin/Bmax) drops, the second axis rotational moment Ty increases.

**Table 1**

| Bmin/Bmax | Tx | Ty |
|---|---|---|
| 1 | 514 | 0 |
| 0.9 | 506 | 23 |
| 0.8 | 498 | 46 |
| 0.7 | 490 | 69 |
| 0.6 | 483 | 92 |
| 0.5 | 475 | 115 |
| 0.4 | 467 | 138 |

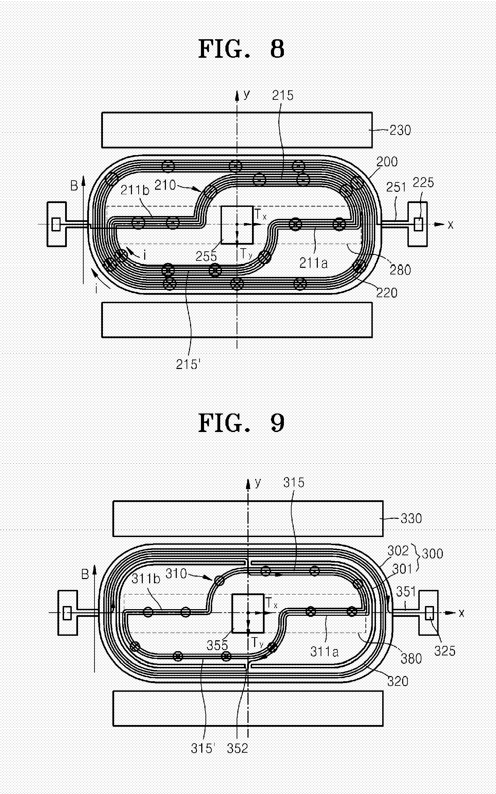

FIG. 8 is a plan view of a MEMS device structure according to other embodiment of the present invention. Below, a detailed description will focus on the differences between the above-described embodiment and the embodiment shown in FIG. 8. The MEMS device according to the present embodiment also includes a moving plate 200 disposed between a pair of magnets 230 facing one another, and a driving coil 210 wound in a predetermined shape on the moving plate 200 and including coaxial coil portions 211a and 211b and connecting coil portions 215 and 215'. Also, an auxiliary coil 220 may be further disposed on the outer edge of the driving coil 210, and the driving coil 210 and the auxiliary coil 220 may receive a driving current (i) from the same connecting terminal 225. The shape and function of the driving coil 210 and the auxiliary coil 220 are the same as the description already given with reference to FIG. 1. A stage 255 is provided in the central portion of the moving plate 200. The stage 255 is not configured to be removable from the moving plate 200, and may form a portion of the moving plate 200 or may be formed on the moving plate 200 as a light reflecting surface.

To elastically support the moving plate 200 that pivots on a first and second axis (x-axis and y-axis), the axis members 251 can twist along their axial direction and bend in a direction vertical to the ground surface. That is, the axis members 251 act as elastic springs that deform to allow the moving plate 200 to rotate about the first axis (x-axis), and bend to allow the moving plate 200 to rotate about the second axis (y-axis). A yoke magnetic body 280 is disposed in a region above or below the magnets 230 and between the magnets 230 to expand the range of a magnetic flux density that is the basis for a driving force Ty about the second axis.

FIG. 9 is a plan view of a MEMS device structure according to other embodiment of the present invention. Referring to FIG. 9, the MEMS device includes a moving plate 300 disposed between a pair of magnets 330 facing one another, and a driving coil 310 wound in a predetermined shape on the moving plate 300. The moving plate 300 includes an outer gimbal 302 pivotably supported about a first axis (x-axis), and an inner gimbal 301 pivotably supported about a second axis (y-axis). A stage 355 is provided at the central portion of the inner gimbal 301, and may have the form of a light reflecting surface formed in an appropriate region. The driving coil 310 is formed on the inner gimbal 301 and includes coaxial coil portions 311a and 311b and connecting coil portions 315 and 315' to provide driving force about the first and second axes (x-axis and y-axis). The outer gimbal 302 may have an auxiliary coil 320 formed thereon to provide driving force about the first axis. The form of the driving coil 310 and the auxiliary coil 320 and the rotational moment induced in the present embodiment are the same as in the embodiments already described. Therefore, the driving force Tx about the first axis is caused by the electromagnetic force induced by the driving coil 310, and the driving force Ty about the second axis is caused by the non-uniformity of the electromagnetic force from the variation in magnetic flux density. The inner and outer gimbals 301 and 302 pivot together about the first axis (x-axis), and the inner gimbal 301 simultaneously pivots about the second axis (y-axis). Here, the outer and inner gimbals 302 and 301 are respectively provided with rotating axes by the first and second axis members 351 and 352, which function as elastic springs that elastically support the pivoting gimbals 301 and 302. A yoke magnetic body 380 made of a magnetic material is disposed between the pair of magnets 330 in a region above or below the magnets, to increase the gradient of the magnetic flux density and strengthen the rotating force Ty about the second axis. Reference number 325 in FIG. 9 refers to a connecting terminal that applies a driving current to the driving coil 310 and the auxiliary coil 320.

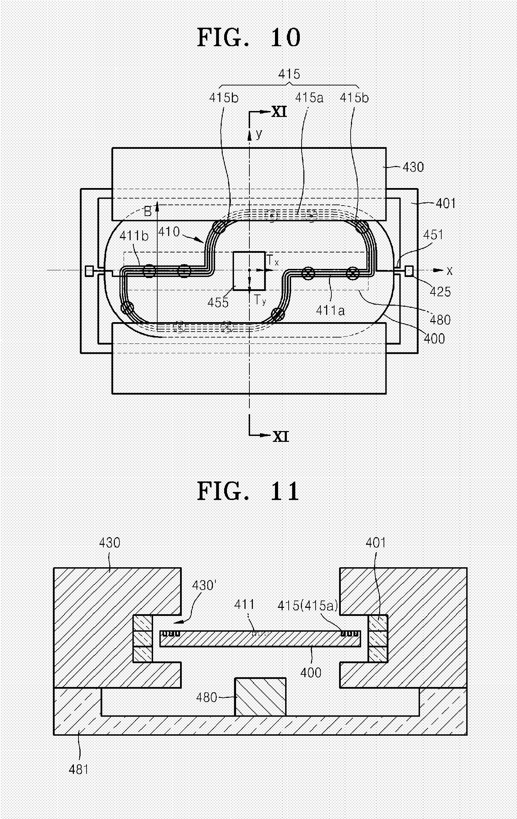

FIGS. 10 and 11 are a plan view of a MEMS device according to yet another embodiment of the present invention and a vertical sectional view of the same. The MEMS device includes a pair of magnets 430 facing one another, a moving plate 400 disposed between the pair of magnets 430 and including an approximately oblong outer frame 401 upon which the moving plate 400 is rotatably supported, a stage 455 formed at the central portion of the moving plate 400, and a driving coil 410 formed on the moving plate by being wound around the stage 455. A yoke magnetic body 480 is disposed at a region between and below the magnets 430.
The moving plate 400 is elastically supported by axis members 451 extending from the outer frame 401 to pivot about a first and second axis (x-axis and y-axis). The shape of the driving coil 410 including connecting coil portions 415 formed with a straight coil portion 415a and a curved coil portion 415b and coaxial coil portions 411a and 411b, and the rotational moments (Tx and Ty) induced thereby about the first and second axes are the same as the embodiment described with reference to FIGS. 1 and 2. Therefore, the pivoting about the first axis is produced by the rotational moment induced by the driving coil 410, and the pivoting about the second axis is produced by the non-uniformity of the rotational moment from the variation in magnetic flux density. In the present embodiment, compared to the magnetic flux density of the coaxial coil portions 411a and 411b, the magnetic flux density of the connecting coil portions 415 is stronger due to the fact that the connecting coil portions 415, more specifically, the straight coil portions 415a are disposed to overlap with the magnets 430. That is, recessed portions 430' are formed into the surfaces of the magnets facing one another, and the moving plate 400 is inserted between the magnets 430 so that the connecting coil portions 415, more specifically, the straight coil portions 415a are disposed in the recessed portions 430'. A moving space is provided for the moving plate 400 to pivot within, and the outer frame 401 is formed with a material of a sufficiently thick film or a multilayer structure of thin films to prevent physical interference between the moving plate 400 and the magnets 430. The yoke magnetic body 480 disposed between and below the pair of magnets 430, as described in other embodiments, favorably alters the distribution of magnetic flux to attain a greater rotating force. A shielding plate 481 attached to the yoke magnetic body 480 shields the inner magnetic field space from the external environment. Reference number 425 in FIG. 10 refers to connecting terminals for electrically connecting either end of the driving coil 410.

In the two-axis MEMS device of the present invention, the electromagnetic force induced in the driving coil provides a driving force about the first axis, and the electromagnetic force variation according to magnetic flux density distribution provides a driving force about the second axis. In the present invention, a yoke magnetic body that induces a sudden change in magnetic flux density is disposed between the magnets in order to increase the rotating force about the second axis. Therefore, the MEMS device provided is suitable for faster driving and a wider displacement. For example, when applied to an optical scanner, a display resolution can be increased through faster light irradiation, and a wider display area can be formed through the wider displacement. In an embodiment of the present invention, by inserting the edge portions of the driving coil in the recessed portions formed in the magnets, the variation in magnetic flux density according to the position of the driving coil can be further increased to double the increase in the driving force.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A MEMS (micro-electro mechanical system) device comprising:
a moving plate supported coaxially on a first axis to move pivotably about the first axis and a second axis that is disposed perpendicularly to the first axis, and including a stage region;
a driving coil including a coaxial coil portion arranged along the first axis of the moving plate and divided at a center by the stage, and a first connecting coil portion and a second connecting coil portion respectively connecting left and right end portions of the coaxial coil portion to one another at opposite ends thereof;
a pair of magnets having opposite polarities and respectively disposed proximally to the first and second connecting coil portions to form a magnetic field transversely across the driving coil; and
a yoke magnetic body disposed between the pair of magnets in a region above or below the magnets and formed of a material capable of being magnetized by the magnets in order to suddenly change a magnetic flux density according to a distance between the pair of magnets.

2. A MEMS device according to claim 1 wherein the stage region is a stage supported coaxially on the second axis in an inner region of the moving plate.

3. A MEMS device according to claim 1 or 2 wherein the stage region is formed at the center of the moving plate.

4. The MEMS device of claim 1, 2 or 3, wherein the yoke magnetic body is formed mainly of iron.

5. The MEMS device of any preceding claim, wherein the moving plate is located between the pair of magnets at a position higher or lower than a perpendicular centerline of the pair of magnets to be disposed close to the yoke magnetic body.

6. The MEMS device of any preceding claim, wherein each magnet of the pair of magnets includes a recessed portion formed in a surface thereof facing the other magnet and recessed in a receding direction from the other magnet, and at least one part of the first and second connecting coil portions is disposed within the recessed portion.

7. The MEMS device of any preceding claim, wherein the first and second connecting coil portions include straight coil portions separated from and running parallel to the first axis, and curved coil portions connecting the straight coil portions to the coaxial coil portions in a rounded manner.

8. The MEMS device of any preceding claim, further comprising an auxiliary coil wound symmetrically about the first and second axes along a perimeter of the moving plate.

9. A MEMS device according to any preceding claim wherein the moving plate comprises a gimbal supported to move about a first axis.
